# DEMANDE DE BREVET EUROPEEN

(11) **EP 3 595 029 A1**
(43) Date de publication de la demande: **15.01.2020**
(21) Numéro de dépôt: 19185089.0
(22) Date de dépôt: 09.07.2019
(51) Int. Cl.: H01L 51/56, H01L 25/00, H01L 21/683, H01L 23/00, H01L 25/075

(54) **PROCÉDÉ DE TRANSFERT DE STRUCTURES**

(30) Priorité: 13.07.2018 FR 1856513
(71) Demandeur: Commissariat à l'énergie atomique et aux énergies alternatives, 75015 Paris (FR)
(72) Inventeur: BENAISSA, Lamine, 38054 GRENOBLE CEDEX 09 (FR)
(74) Mandataire: Brevalex

(57) **Abrégé**

L'invention concerne un procédé de transfert de structures (200) sur un substrat d'accueil (400), le procédé comprenant les étapes successives suivantes :
a) la fourniture d'un substrat temporaire (100) comprenant deux faces principales le substrat temporaire (100) étant étirable, des structures (200) étant assemblées selon leur face avant (210), sur la première face ;
b) étirer le substrat temporaire (100) selon au moins une direction de manière à augmenter l'espacement selon l'au moins une direction entre les structures (200),
c) une étape de report de la pluralité de structures (200) sur une face d'accueil (410) d'un substrat d'accueil (400),

Le substrat temporaire (100) comprend une matrice (101) faite d'un matériau étirable, et une pluralité d'inserts sur lesquels sont assemblées les structures (200), les inserts comprenant un matériau présentant un module d'Young supérieur à celui du matériau étirable.

## Description

### DOMAINE TECHNIQUE

La présente invention concerne un procédé de report de structures sur une face d'accueil d'un substrat d'accueil. Notamment, la présente invention met en oeuvre un substrat temporaire étirable pourvu d'inserts destinés à minimiser, voire prévenir, l'apparition de contraintes au niveau des structures lors de l'étirement du substrat temporaire.

### ÉTAT DE LA TECHNIQUE ANTÉRIEURE

Un procédé de transfert de structures connu de l'état technique est décrit dans le document [1] cité à la fin de la description et illustré aux figures la à 1c.

Le procédé connu de l'état de la technique comprend notamment les étapes successives suivantes :
a) la fourniture d'un substrat temporaire comprenant deux faces principales, essentiellement parallèles, dites respectivement première et seconde face, le substrat temporaire étant étirable, une pluralité de structures étant assemblés selon une de leur face, dite face avant, sur la première face ;
b) étirer le substrat temporaire selon au moins une direction de manière à augmenter l'espacement selon l'au moins une direction entre les structures,
c) une étape de report de la pluralité de structures sur une face d'accueil d'un substrat final.

L'étape a) est généralement précédée d'une étape de prélèvement de la pluralité de structures qui reposent par une de leur face, opposée à la face avant, dite face arrière, sur une face, dite face initiale, d'un substrat initial.

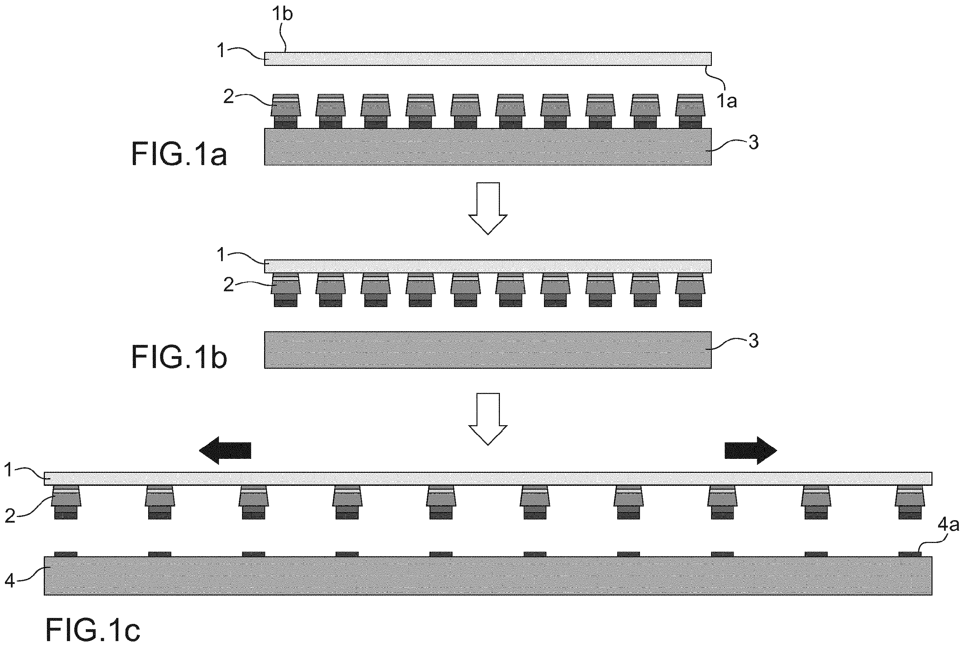

En particulier, l'étape de prélèvement (figure 1a) peut comprendre l'assemblage de la première face du substrat temporaire avec la face avant de chacune des structures, suivie du détachement desdites structures de la face initiale (figure 1b).

À cet égard, l'adhésion entre la face arrière et la face initiale est généralement ajustée pour faciliter l'étape de prélèvement.

Notamment, l'adhésion entre la face arrière et la face initiale peut présenter une énergie inférieure à l'énergie d'adhésion des structures sur la première face du substrat temporaire, de sorte que le détachement s'effectue de manière sélective entre la face initiale du substrat initial et la face arrière des structures.

Le substrat temporaire proposé dans [1] est un substrat étirable. En d'autres termes, le substrat temporaire est fait d'un matériau dont le module Young est suffisamment faible pour étirer ledit substrat temporaire selon au moins une direction, dite direction d'étirement. Le matériau, selon [1], peut notamment comprendre un matériau polymère flexible, et en particulier un élastomère.

Par « élastomère », on entend un polymère qui présente des propriétés élastiques et est susceptible, sous l'effet d'une traction ou d'un étirement, de présenter une forte déformation avant rupture. Plus particulièrement, la mesure de l'élasticité d'un matériau est quantifiée par son module d'Young, et un matériau sera considéré comme étirable dès lors que son module d'Young est inférieur à 0,1 GPa.

L'étape b) du procédé connu de l'état de la technique comprend l'application d'une force de traction au substrat temporaire selon au moins une direction, comprise dans le plan formé par la première face, de manière à étirer ledit substrat (figure le). De cet étirement résulte une augmentation de l'espacement entre les structures avant leur report sur la face d'accueil du substrat d'accueil.

Ce procédé est alors mis en oeuvre dès lors qu'il s'agit de transférer des structures selon un agencement ou espacement différent entre lesdites structures d'un substrat à l'autre, venant ainsi palier les problèmes de coûts et de temps de cycle associés au transfert de structures par placement individuel (« Pick and Place » selon la terminologie anglo-saxonne).

Cependant, ce procédé de transfert massif de structures n'est pas non plus satisfaisant.

En effet, l'étirement, à l'étape b), du substrat temporaire n'est pas uniforme. Notamment les zones de contact entre les structures et la face temporaire ne sont pas soumises à la même amplitude d'étirement que le reste du substrat temporaire.

Cette non uniformité d'étirement affecte, et notamment réduit, l'adhésion des structures sur la face temporaire. Elle compromet également l'alignement dans le plan des structures. L'amplitude d'étirement est donc limitée de manière à garantir l'adhésion des structures sur la surface temporaire ainsi que leur planéité.

Par ailleurs, l'étirement impose également une contrainte au niveau des structures, et peut ainsi provoquer une déformation de ces dernières.

En outre, l'efficacité du prélèvement des structures sur le substrat initial est, en partie, régie par l'énergie d'adhésion des structures au matériau formant le substrat temporaire, et une sélectivité de prélèvement ne peut être assurée pour tous les matériaux étirables.

Enfin, l'élasticité du substrat temporaire ne permet pas d'exercer une pression entre le substrat temporaire et le substrat d'accueil afin de renforcer l'énergie d'adhésion entre les structures et la face d'accueil lors de l'étape c) de report.

Un but de la présente invention est donc de proposer un procédé de transfert, collectif, de structures via un substrat temporaire étirable permettant des étirements bien supérieurs à ceux connus de l'état de la technique.

Un autre but de la présente invention est de proposer un procédé de transfert, collectif de structures via un substrat temporaire étirable permettant un prélèvement efficace (autrement dit « sélectif ») sur le substrat initial.

Un autre but de la présente invention est de proposer un procédé de transfert, collectif, de structures via un substrat temporaire étirable susceptible de supporter l'application d'une pression afin de renforcer l'énergie d'adhésion entre les structures et le substrat d'accueil lors d'une étape de report.

### EXPOSÉ DE L'INVENTION

Les buts de la présente invention sont, au moins en partie, atteints par un procédé de transfert de structures sur un substrat d'accueil, le procédé comprenant les étapes successives suivantes :
a) une étape de fourniture d'un substrat temporaire comprenant deux faces principales dites, respectivement, première et seconde face, le substrat temporaire étant étirable, une pluralité de structures, comprenant chacune une face avant et une face arrière, étant assemblées selon leur face avant, sur la première face ;
b) une étape d'étirement le substrat temporaire selon au moins une direction de manière à augmenter l'espacement selon l'au moins une direction entre les structures,
c) une étape de report de la pluralité de structures sur une face d'accueil d'un substrat d'accueil,

Le procédé étant remarquable en ce que le substrat temporaire comprend une matrice faite d'un matériau étirable, et une pluralité d'inserts sur lesquels sont assemblées les structures, les inserts comprenant un matériau présentant un module d'Young supérieur à celui du matériau étirable.

Selon un mode de mise en oeuvre, l'étape a) est précédée d'une étape de prélèvement a1) des structures disposées selon leur face arrière, sur une face, dite face initiale, d'un substrat initial.

Selon un mode de mise en oeuvre, l'agencement des inserts du substrat temporaire est en correspondance avec l'agencement des structures sur la face initiale lors de l'étape de prélèvement a1).

Selon un mode de mise en oeuvre, l'étape de prélèvement a1) comprend successivement :
- un assemblage de la face avant des structures avec les inserts,
- un détachement, dit premier détachement, des structures du substrat initial.

Selon un mode de mise en oeuvre, le premier détachement nécessite une énergie, dite première énergie de détachement, ajustée pour être inférieure à l'énergie d'adhésion entre la face avant des structures et les inserts.

Selon un mode de mise en oeuvre, la première énergie de détachement est inférieure à 0,3 J/m².

Selon un mode de mise en oeuvre, l'ajustement de la première énergie de détachement comprend une étape de fragilisation de l'interface entre la face initiale et la face arrière, avantageusement, l'étape de fragilisation comprend une réduction de la surface de contact entre la face initiale et la face arrière.

Selon un mode de mise en oeuvre, l'étape b) comprend un premier étirement selon une première direction et un second étirement selon une seconde direction, différente de la première direction, destinés à augmenter l'espacement entre les structures selon les première et seconde directions.

Selon un mode de mise en oeuvre, l'étape c) comprend successivement :
- un assemblage des structures avec le substrat d'accueil par mise en contact desdites structures par leur face arrière avec la face d'accueil du substrat d'accueil,
- un détachement, dit second détachement, des structures des inserts de manière à transférer lesdites structures sur la face d'accueil.

Selon un mode de mise en oeuvre, le second détachement des structures des inserts est précédé d'une étape de renforcement de l'assemblage des structures avec le substrat d'accueil.

Selon un mode de mise en oeuvre, l'énergie d'adhésion des structures sur les inserts est inférieure à l'énergie d'adhésion des structures sur la face d'accueil.

Selon un mode de mise en oeuvre, le matériau étirable comprend un élastomère, notamment, l'élastomère comprend au moins un des matériaux choisi parmi : caoutchouc de butyle, caoutchouc naturel, caoutchouc styrène butadiène, elastomères de silicone, éthylène acétate de vinyle, isoprène, polchloroprène, polychloroprène, polyuréthane.

Selon un mode de mise en oeuvre, les inserts sont émergents au niveau des deux faces principales du substrat temporaire.

Selon un mode de mise en oeuvre, les inserts comprennent un matériau transparent dans le domaine de longueurs d'onde UV, avantageusement le matériau transparent comprend du verre.

Selon un mode de mise en oeuvre, les inserts comprennent un matériau semi-conducteur, avantageusement le matériau semi-conducteur comprend au moins un des matériaux choisi parmi : silicium, germanium...

Selon un mode de mise en oeuvre, le substrat d'accueil comprend sur sa face d'accueil des sites, dits sites d'accueil, sur lesquels sont reportées les structures, les sites d'accueil étant adaptés pour favoriser l'adhésion des structures sur lesdits sites d'accueil par rapport à l'adhésion desdites structure sur la première face.

Les sites d'accueil peuvent comprendre au moins des éléments choisi parmi : billes de brasure, des micro tubes, des empilements métallique permettant une adhésion des structures sur la face d'accueil par collage eutectique ou thermocrompressif, des matériaux magnétiques, une colle polymère.

L'invention concerne aussi un procédé de transfert des structures d'un premier type, d'un second type et d'un troisième type sur un substrat d'accueil, le procédé comprenant successivement le transfert, selon la présente invention, des structures du premier type, du second type et du troisième type sur le substrat d'accueil.

Selon un mode de mise en oeuvre, les structures du premier type, du second type et du troisième type émettant chacune dans un domaine de longueur d'onde différent.

### BRÈVE DESCRIPTION DES DESSINS

D'autres caractéristiques et avantages apparaîtront dans la description qui va suivre d'un procédé de transfert selon l'invention, donnés à titre d'exemples non limitatifs, en référence aux dessins annexés dans lesquels :
- les figures la à 1c sont des représentations schématiques d'un procédé de transfert impliquant un substrat étirable connu de l'état de la technique ;
- les figures 2a à 2e sont des représentations schématiques des différentes étapes du procédé de transfert de structures sur un substrat d'accueil selon la présente invention ;
- la figure 3 est une représentation schématique d'une étape de fragilisation, de l'interface entre les structures et la face initiale, mise en oeuvre pour le premier détachement ;
- les figures 4a à 4f sont des représentations schématiques des différentes étapes de transfert de LED de type différent, notamment pour la formation d'afficheurs.

### EXPOSÉ DÉTAILLÉ DE MODES DE RÉALISATION PARTICULIERS

La présente invention concerne un procédé de transfert de structures sur une face, dite face d'accueil, d'un substrat d'accueil.

En particulier, l'étape de transfert met en oeuvre un substrat temporaire étirable, et une face sur laquelle sont disposées les structures. Le substrat temporaire est, à cet égard, destiné à être étiré selon au moins une direction, avant report des structures sur la face d'accueil, de manière à augmenter l'espacement entre lesdites structures.

Selon les termes de la présente invention, le substrat temporaire comprend par ailleurs une matrice faite d'un matériau étirable, ainsi que des inserts faits d'un matériau présentant un module d'Young supérieur à celui du matériau étirable, et sur lesquels sont disposées les structures.

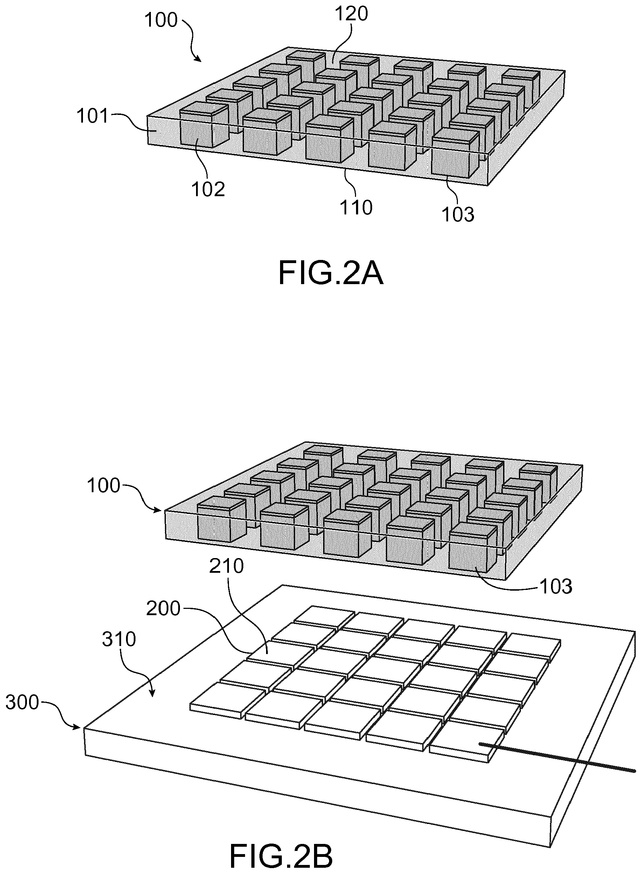

Les figures 2a à 2e illustrent, de façon schématique, les différentes étapes du procédé de transfert de structures selon la présente invention.

En particulier, le procédé selon la présente invention comprend une étape a) de fourniture d'un substrat temporaire 100 qui comprend deux faces principales, essentiellement parallèles, dites, respectivement, première face 110 et seconde face 120 (figure 2a).

Le substrat temporaire 100 est étirable.

Par « étirable », on entend un substrat temporaire 100 qui peut être fortement étiré ou étendu avant de rompre. L'étirement du substrat temporaire correspond alors à une élongation dudit substrat selon une direction donnée en réponse à un effort de traction selon ladite direction donnée.

La direction donnée peut par exemple être une direction comprise dans un plan défini par l'une ou l'autre des faces principales du substrat temporaire 100.

Selon la présente invention, un substrat temporaire est étirable s'il peut subir une élongation sans rompre selon une direction comprise dans un plan défini par une de ses faces principales d'au moins 20 %.

L'élongation est avantageusement une déformation élastique de sorte que ledit substrat reprend sa forme initiale dès lors que l'effort de traction est interrompu.

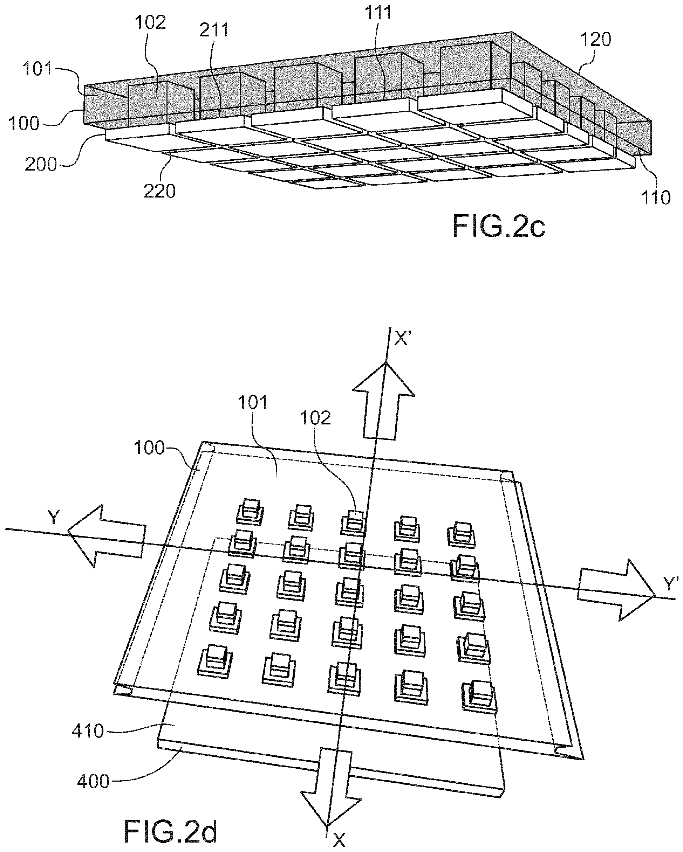

Une pluralité de structures 200, comprenant chacune une face avant 210 et une face arrière 220, sont assemblées, selon leur face avant 210, sur la première face 110 du substrat temporaire 100 (figure 2c).

Par « assemblées », on entend que les structures sont maintenues au substrat temporaire par adhésion de leur face avant sur la première face dudit substrat.

En particulier, le contact entre la face avant 210 et la première face 110 forme une interface dite interface de contact temporaire 111.

Le substrat temporaire 100 comprend, par ailleurs, une matrice 101 faite d'un matériau étirable et une pluralité de d'inserts 102 sur lesquels sont assemblées les structures 200 (figures 2a et 2c).

Par « insert », on entend un élément volumique compris dans le substrat temporaire, et susceptible d'émerger selon l'une et/ou l'autre de la première face 210 et de la seconde face 220 du substrat temporaire.

Il est entendu que chaque structure 200 assemblée sur la première face 110 est en contact avec un insert 102. En d'autres termes, chaque insert est au moins émergeant de la première face 110 par une face dite première face émergente 103 (figure 2a).

Par ailleurs, le contact entre la face avant 210 et la première face 110 peut s'effectuer exclusivement au niveau d'un insert 102. En d'autres termes, l'interface de contact temporaire 111 est circonscrite par le contour de la première face émergente 103.

Les inserts 102 sont avantageusement faits d'un matériau qui présente un module d'Young supérieur au module d'Young du matériau étirable. En d'autres termes, les inserts 102 sont « moins étirables » que la matrice.

De manière particulièrement avantageuse, le matériau étirable peut comprendre un matériau élastomère, par exemple du Caoutchouc de silicone.

Le matériau formant les inserts 102 présente avantageusement un module d'Young supérieur à 40 GPa.

Le matériau formant les inserts peut comprendre au moins un des matériaux choisi parmi :
- un métal, par exemple du cuivre ou de l'aluminium,
- un alliage métallique
- un verre, une céramique,
- un semi-conducteur, par exemple du silicium, du germanium, un alliage de silicium et de germanium.

Les structures 200 assemblées sur la première face 110 peuvent, au cours d'une étape a1) précédant l'étape a), avoir été prélevées, selon leur face arrière 220, d'une face initiale 310 d'un substrat initial 300 (figure 2b).

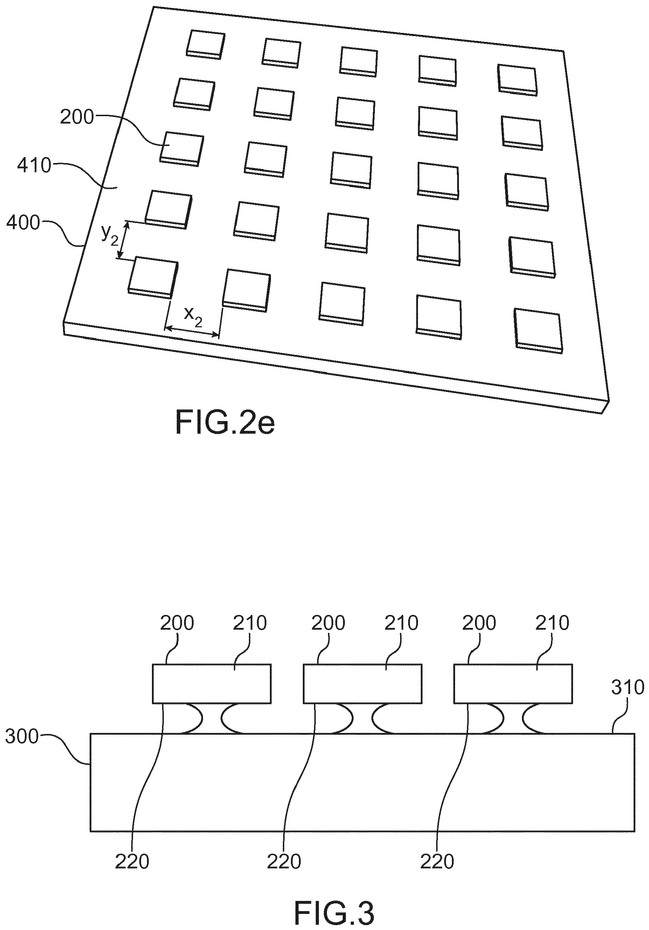

En particulier, l'étape de prélèvement a1) peut comprendre successivement :
1a1) un assemblage de la face avant 210 de chacune des structures 200 avec un insert 102, plus particulièrement avec la première face émergente 103 d'un insert 102,
2a1) un détachement, dit premier détachement, des structures du substrat initial 300 (figure 3).

L'étape 1a1) peut comprendre une étape de collage direct par la mise en contact des premières faces émergentes 103 avec les faces avant 210.

De manière avantageuse, l'agencement des inserts 102 du substrat temporaire 100 est en correspondance avec l'agencement des structures 200 sur la face initiale 310. En d'autres termes, lors de l'exécution de l'étape 1a1), chaque insert 102 est mis en contact avec une structure 200.

À cet égard, les structures peuvent être agencées de manière matricielle sur la face initiale, sans toutefois limiter la présente invention à cet agencement.

Par « agencées de manière matricielle », on entend un arrangement de structures régulier et périodique selon des directions X et Y différentes l'une de l'autre et comprises dans un plan défini par la face sur laquelle reposent lesdites structures.

Il est entendu que l'étape de prélèvement a1) ne modifie pas cet agencement matriciel des structures.

Par ailleurs, des structures 200 agencées de manière matricielle imposent un agencement identique aux inserts 102.

L'étape 2a1), de premier détachement, peut nécessiter une énergie, dite première énergie de détachement, ajustée pour être inférieure à l'énergie d'adhésion entre la face avant 210 des structures 200 et la première face émergente 103, dite énergie d'adhésion temporaire. Ainsi, cette hiérarchisation des énergies d'adhésions permet de prélever efficacement l'ensemble des structures 200.

La première énergie d'adhésion peut, par exemple, être ajustée par un choix approprié du matériau formant la face initiale.

De manière alternative ou complémentaire, la première énergie d'adhésion peut également être ajustée en fragilisant l'interface entre la face initiale 310 du substrat initial 300 et la face arrière 220 des structures 200.

Cette étape de fragilisation peut par exemple comprendre une réduction de la surface de contact entre la face arrière 220 des structures 200 et la face initiale 310 du substrat initial 300.

La réduction de surface peut être obtenue par une étape de gravure, notamment par voie liquide, au niveau de l'interface formée par la face arrière 220 et la face initiale 310. Notamment, l'étape de gravure peut comprendre un retrait partiel du matériau formant la face initiale 310 en contact avec la face arrière 220.

L'ajustement de la première énergie de détachement peut alors être exécuté de sorte que cette dernière soit inférieure à 0,3 J/m².

De manière complémentaire, l'énergie d'adhésion temporaire est avantageusement supérieure à 0,5 J/m².

L'étape a) peut alors être suivie d'une étape b) qui consiste à étirer le substrat temporaire 100 selon au moins une direction de manière à augmenter l'espacement selon l'au moins une direction entre les structures 200.

Il est entendu, sans qu'il soit nécessaire de le préciser, que l'espacement entre les structures 200 est mesuré selon une direction comprise dans un plan défini par la première face 110.

L'étape b) d'étirement du substrat temporaire 100 peut être exécutée en exerçant un effort de traction sur ledit substrat selon l'au moins une direction de manière à mettre ce dernier en tension (figure 2d).

De cette mise en tension résulte un écartement des structures les unes des autres.

Les structures 200, dès lors qu'elles reposent sur des inserts 102 « moins étirables » que la matrice, sont alors moins affectées par l'élongation du substrat temporaire.

En particulier, les structures 200 subissent moins la déformation du substrat temporaire 100 de sorte que leur adhésion audit substrat est préservée lors de l'étirement.

Il est par conséquent possible d'envisager une gamme d'étirement plus importante qu'avec un substrat temporaire dépourvu d'inserts.

L'étape b) d'étirement peut comprendre un premier étirement exécutée selon une première direction XX' et un second étirement selon une seconde direction YY' différente de la première direction, de manière à augmenter l'espacement entre les structures selon les première et seconde directions. Le premier et le second étirement peuvent être d'amplitudes différentes.

L'étape b) est suivie d'une étape c) de report de la pluralité de structures sur une face d'accueil 410 d'un substrat d'accueil 400 (figure 2d et 2e).

L'étape c) de report peut comprendre les étapes suivantes :
1c) un assemblage des structures 200 avec le substrat d'accueil 400 par mise en contact desdites structures 200 par leur face arrière 220 avec la face d'accueil 410 du substrat d'accueil 400,
2c) un détachement, dit second détachement, des structures 200 des inserts 102 de manière à transférer lesdites structures 200 sur la face d'accueil 410.

L'étape 1c) d'assemblage comprend avantageusement un collage par adhésion moléculaire (ou collage direct).

Par ailleurs, l'énergie d'adhésion entre les structures 200 et la face d'accueil 410, dite énergie d'adhésion d'accueil, est avantageusement supérieure à l'énergie d'adhésion temporaire. Par exemple l'énergie d'adhésion d'accueil peut être supérieure à 1 J/m².

L'étape 1c) peut être accompagnée d'un renforcement de l'énergie d'adhésion d'accueil, par exemple en pressant les substrats temporaire 100 et d'accueil 400 l'un contre l'autre. À cet égard, les inserts 102 sont avantageusement émergeants également selon la seconde face 120. En effet, lesdits inserts 102 présentent la rigidité nécessaire pour transmettre un effort de pression au niveau de l'interface formée par la face arrière 220 des structures 200 et la face d'accueil 410 du substrat d'accueil 400, et ainsi renforcer l'énergie d'adhésion d'accueil.

L'étape 2c) peut être exécutée par fragilisation de l'interface de contact temporaire 111.

Cette fragilisation peut comprendre un effort consistant à décoller le substrat temporaire 100 des structures 200. L'effort peut être exercé par exemple en insérant une lame au niveau de l'interface de contact temporaire 111.

La fragilisation peut également être exécutée par apport d'énergie lumineuse au niveau de l'interface de contact temporaire 111 destinée à générer le décollement des structures 200 du substrat temporaire 100.

En particulier, l'apport d'énergie lumineuse peut comprendre la mise en oeuvre d'un rayonnement laser incident au niveau de l'interface de contact temporaire 111, par exemple un laser UV. À cet égard, les inserts 102 sont avantageusement faits d'un matériau transparent au rayonnement laser mis en oeuvre lors du détachement. Par exemple, les inserts 102 sont faits d'un matériau transparent au rayonnement UV, par exemple du verre.

Par « rayonnement UV », on entend un rayonnement dans la gamme de longueurs d'ondes 315-400 nm.

De manière avantageuse, le substrat d'accueil 400 comprend sur sa face d'accueil 410 des sites, dits sites d'accueil, sur lesquels sont reportées les structures 200, les sites d'accueil étant adaptés pour favoriser l'adhésion des structures sur lesdits sites d'accueil par rapport à l'adhésion desdites structure sur la première face.

Selon cette caractéristique avantageuse, l'ensemble des structures restent sur les sites d'accueil lors du détachement du substrat temporaire 100.

Les sites d'accueil peuvent comprendre au moins des éléments choisi parmi : billes de brasure, des micro tubes, des empilements métallique permettant une adhésion des structures sur la face d'accueil par collage eutectique ou thermocrompressif, des matériaux magnétiques, une colle polymère.

Les structures 200 selon la présente invention peuvent comprendre tout type de cellule ou d'empilement de films. Notamment, les structures 200 peuvent comprendre au moins une des structures type choisie parmi : lentilles, réflecteurs, empilement de couches, des plots, des composant CMOS, des LED, des modules LED et CMOS tels que décrits dans la demande de brevet [2] citée à la fin de la description, des couches de conversions.

La présente invention peut avantageusement être mise en oeuvre pour le report de différents types de structures sur un même substrat d'accueil.

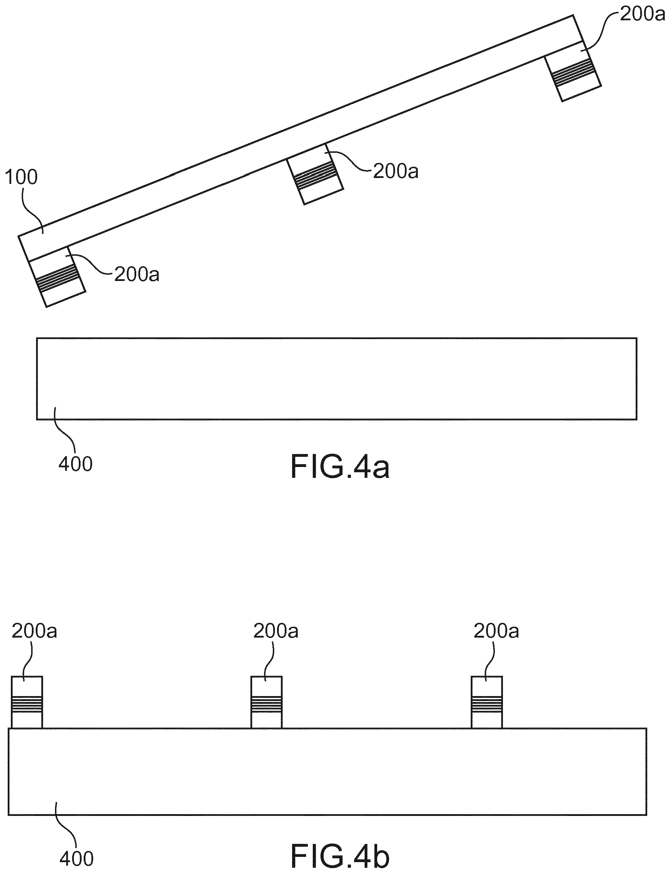

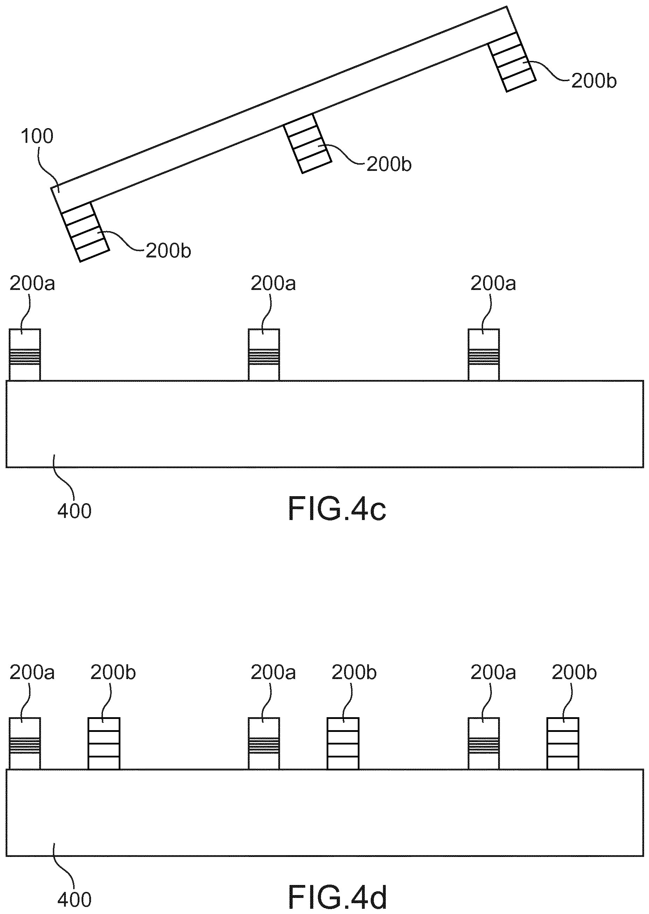

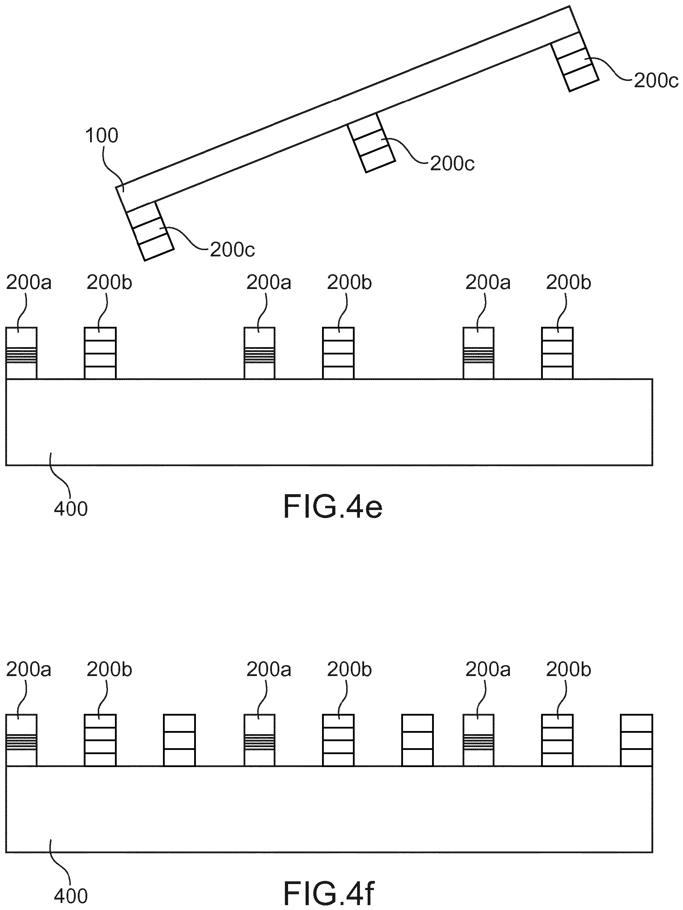

Par exemple, l'invention peut être mise en oeuvre pour le report de structures 200 d'un premier type, dites premières structures 200a, puis de structures d'un second type, dites secondes structures 200b, sur un même substrat d'accueil 400 (figures 4a à 4f).

Les premières structures 200a et les secondes structures 200b sont alors reportées sur la face d'accueil du substrat d'accueil, respectivement, selon un premier agencement et un second agencement.

Le premier et le second agencement peuvent être identiques, et décalés selon une direction comprise dans un plan formé par la face d'accueil.

Des structures 200 d'un troisième type, dites troisièmes structures 200c, peuvent également être reportées selon un troisième agencement identique au premier agencement et décalé des premier et second agencements selon une direction comprise dans un plan formé par la face d'accueil.

De manière particulièrement avantageuse, l'invention peut ainsi être mise en oeuvre pour la formation d'afficheurs. Notamment, les premières, secondes et troisièmes structures comprennent, respectivement, des LED bleues, des LED vertes, et des LED rouges (par « LED » on entend une diode électroluminescente).

Une LED bleue est une LED émettant un rayonnement lumineux dans la gamme de longueurs d'ondes 300nm-500nm.

Une LED rouge est une LED émettant un rayonnement lumineux dans la gamme de longueurs d'ondes 600nm-700nm.

Une LED verte est une LED émettant un rayonnement lumineux dans la gamme de longueurs d'ondes 500nm-600nm.

La formation du substrat temporaire peut comprendre les étapes suivantes :
- fourniture d'un substrat fait du matériau destiné à former des inserts ;
- formation des inserts par une étape de gravure partielle du substrat à travers un masque définissant lesdits inserts, lesdits inserts reposant sur un reliquat de substrat à l'issue de l'étape de gravure ;
- formation d'une couche de matériau étirable, destinée à former la matrice, comblant au moins l'espace inter inserts ;
- retrait du reliquat de substrat afin de libérer un substrat temporaire formé par la matrice et les inserts.

### REFERENCE

[1] US 2016/111604
[2] FR 1561421

## Revendications

1. Procédé de transfert de structures (200) sur un substrat d'accueil (400), le procédé comprenant les étapes successives suivantes :
a) une étape de fourniture d'un substrat temporaire (100) comprenant deux faces principales dites, respectivement, première et seconde face (120), le substrat temporaire (100) étant étirable, une pluralité de structures (200), comprenant chacune une face avant (210) et une face arrière (220), étant assemblées selon leur face avant (210), sur la première face (110) ;
b) une étape d'étirement du substrat temporaire (100) selon au moins une direction de manière à augmenter l'espacement selon l'au moins une direction entre les structures (200),
c) une étape de report de la pluralité de structures (200) sur une face d'accueil (410) d'un substrat d'accueil (400),
le procédé **étant caractérisé en ce que** le substrat temporaire (100) comprend une matrice (101) faite d'un matériau étirable, et une pluralité d'inserts (102) sur lesquels sont assemblées les structures (200), les inserts (102) comprenant un matériau présentant un module d'Young supérieur à celui du matériau étirable.

2. Procédé selon la revendication 1, dans lequel l'étape a) est précédée d'une étape de prélèvement a1) des structures (200) disposées selon leur face arrière (220), sur une face, dite face initiale (310), d'un substrat initial (300).

3. Procédé selon la revendication 2, dans lequel l'agencement des inserts (102) du substrat temporaire (100) est en correspondance avec l'agencement des structures (200) sur la face initiale (310) lors de l'étape de prélèvement a1).

4. Procédé selon la revendication 2 ou 3, dans lequel l'étape de prélèvement a1) comprend successivement :
- un assemblage de la face avant (210) des structures (200) avec les inserts (102),
- un détachement, dit premier détachement, des structures (200) du substrat initial (300).

5. Procédé selon la revendication 4, dans lequel le premier détachement nécessite une énergie, dite première énergie de détachement, ajustée pour être inférieure à l'énergie d'adhésion entre la face avant (210) des structures (200) et les inserts (102).

6. Procédé selon la revendication 5, dans lequel la première énergie de détachement est inférieure à 0,3 J/m².

7. Procédé selon la revendication 5 ou 6, dans lequel l'ajustement de la première énergie de détachement comprend une étape de fragilisation de l'interface entre la face initiale (310) et la face arrière (220), avantageusement, l'étape de fragilisation comprend une réduction de la surface de contact entre la face initiale (310) et la face arrière (220).

8. Procédé selon l'une des revendications 1 à 7, dans lequel l'étape b) comprend un premier étirement selon une première direction et un second étirement selon une seconde direction, différente de la première direction, destinés à augmenter l'espacement entre les structures (200) selon les première et seconde directions.

9. Procédé selon l'une des revendications 1 à 8, dans lequel l'étape c) comprend successivement :
- un assemblage des structures (200) avec le substrat d'accueil (400) par mise en contact desdites structures (200) par leur face arrière (220) avec la face d'accueil (410) du substrat d'accueil (400),
- un détachement, dit second détachement, des structures (200) des inserts (102) de manière à transférer lesdites structures (200) sur la face d'accueil (410).

10. Procédé selon la revendication 9, dans lequel le second détachement des structures (200) des inserts (102) est précédé d'une étape de renforcement de l'assemblage des structures (200) avec le substrat d'accueil (400).

11. Procédé selon la revendication 9 ou 10, dans lequel l'énergie d'adhésion des structures (200) sur les inserts (102) est inférieure à l'énergie d'adhésion des structures (200) sur la face d'accueil (410).

12. Procédé selon l'une des revendications 1 à 11, dans lequel le matériau étirable comprend un élastomère, notamment, l'élastomère comprend au moins un des matériaux choisi parmi : caoutchouc de butyle, caoutchouc naturel, caoutchouc styrène butadiène, elastomères de silicone, éthylène acétate de vinyle, isoprène, polchloroprène, polychloroprène, polyuréthane.

13. Procédé selon l'une des revendications 1 à 12, dans lequel les inserts (102) sont émergents au niveau d'au moins la première face (110) parmi les deux faces principales du substrat temporaire (100).

14. Procédé selon l'une des revendications 1 à 13, dans lequel les inserts (102) comprennent un matériau transparent dans le domaine de longueurs d'onde UV, le matériau transparent comprenant avantageusement du verre.

15. Procédé selon l'une des revendications 1 à 13, dans lequel les inserts (102) comprennent un matériau semi-conducteur, le matériau semi-conducteur comprenant avantageusement au moins un des matériaux choisi parmi : silicium, germanium.

16. Procédé selon l'une des revendications 1 à 15, dans lequel le substrat d'accueil (400) comprend sur sa face d'accueil (410) des sites, dits sites d'accueil, sur lesquels sont reportées les structures (200), les sites d'accueil étant adaptés pour favoriser l'adhésion des structures (200) sur lesdits sites d'accueil par rapport à l'adhésion desdites structure (200) sur la première face (110).

17. Procédé selon la revendication 16, dans lequel les sites d'accueil comprennent au moins des éléments choisi parmi : billes de brasure, des micro tubes, des empilements métallique permettant une adhésion des structures (200) sur la face d'accueil (410) par collage eutectique ou thermocrompressif, des matériaux magnétiques, une colle polymère.

18. Procédé de transfert des structures (200) d'un premier type, d'un second type et d'un troisième type sur un substrat d'accueil (400), le procédé comprenant successivement le transfert, selon l'une des revendications 1 à 17 des structures (200) du premier type, du second type et du troisième type sur le substrat d'accueil (400).

19. Procédé selon la revendication 18, dans lequel les structures (200) du premier type, du second type et du troisième type sont des LED émettant chacune dans un domaine de longueur d'onde différent.
